# EUROPEAN PATENT SPECIFICATION

(11) **EP 3 809 454 B1**
(45) Date of publication and mention of the grant of the patent: **03.05.2023**
(21) Application number: 19819693.3
(22) Date of filing: 22.03.2019
(51) Int. Cl.: H01L 21/673, B65G 1/02, H01L 21/677

(54) **STORAGE SHELF**
LAGERREGAL
COMPARTIMENT DE STOCKAGE

(30) Priority: 15.06.2018 JP 2018114816
(43) Date of publication of application: 21.04.2021
(73) Proprietor: Murata Machinery, Ltd., Kyoto-shi, Kyoto 601-8326 (JP)
(72) Inventor: TSUBAKI, Tatsuo, Ise-shi, Mie 516-0005 (JP); ONISHI, Shinji, Ise-shi, Mie 516-0005 (JP)
(74) Representative: Jordan, Volker Otto Wilhelm
(86) International application number: PCT/JP2019/012222
(87) International publication number: WO 2019/239672

(56) References cited:
- EP-A1- 2 958 138
- JP-A- 2010 182 747
- JP-A- 2010 182 747
- JP-A- 2015 126 203
- JP-A- 2016 141 565
- JP-A- 2016 141 565
- JP-B2- 6 061 020
- US-A1- 2017 140 965
- US-A1- 2017 243 776
- US-A1- 2018 012 779

## Description

### Technical Field

One aspect of the present invention relates to a storage shelf.

### Background Art

Examples of known storage shelves configured to store therein containers include a front-opening unified pod (FOUP) configured to accommodate wafers to be processed in a semiconductor manufacturing device or a liquid crystal manufacturing device, for example, and a reticle pod configured to accommodate reticles to be used in the semiconductor manufacturing device or the liquid crystal manufacturing device. Such a storage shelf is installed in a manner suspended from a supported member of a track for overhead transport vehicles or a ceiling, for example, or is installed in a manner standing on the ground. The storage shelf thus installed may be subjected to vibrations transmitted during travel of aerial transportation or ground transportation. For example, Patent Document 1 discloses a storage shelf including a shelf plate (placement unit) on which a container is placed and a body frame (frame unit) supporting the shelf plate, in which the shelf plate is supported by the body frame with elastic bodies interposed therebetween. This storage shelf is capable of reducing influence of vibrations transmitted to the shelf plate.

### Citation List

### Patent Literature

[Patent Document 1] Japanese Patent No. 6061020

### Summary of Invention

### Technical Problem

In order to maintain cleanliness of contained objects, it may be desired for above-described storage shelf to be provided with a purging apparatus configured to feed purge gas such as inert gas or clean dry air to the container. However, when the shelf plate is provided with the purging apparatus, vibration isolation for the shelf plate may be hindered by a feed tube through which the purge

The nearest state of the art regarding the present invention is disclosed in EP 2 958 138 A1. This document already shows: a storage shelf including a body frame and a plate-like shelf plate, the body frame including a plate-like base member, the shelf plate being attached to the base member with an elastic body interposed therebetween, the storage shelf configured to store therein a container containing a contained object.

Further, JP 2010 182 747 A discloses a storage shelf with fixed shelf plates provided with feed nozzles communicating via rigid feed tubes with a main tube and a transport mechanism for transporting containers to the storage shelf storage places provided with an auxiliary purge mechanism, which uses a flexible hose to provide a purge gas also during the transport to the container. gas is fed to the container, and vibrations may be transmitted to the shelf plate via the feed tube.

In view of this, it is an object of one aspect of the present invention to provide a storage shelf that can prevent vibrations from being transmitted to the container even when the shelf plate is provided with the purging apparatus.

### Solution to Problem

A storage shelf according to one aspect of the present invention is a storage shelf including a body frame and a shelf plate attached to the body frame with an elastic body interposed therebetween, the storage shelf configured to store therein a container containing a contained object. The storage shelf also includes: a feed nozzle provided on the shelf plate and configured to feed gas to the container; and a feed tube having one end communicating with the feed nozzle and the other end communicating with a main tube connected to a feed source of the gas to be fed to the container, the main tube being supported by a support separate from the shelf plate. The feed tube has a flexible part having flexibility at least partially between the one end and the other end.

In the storage shelf thus configured, at least part, along the entire length, of the feed tube connected to the feed nozzle provided on the shelf plate has flexibility. Thus, the feed tube can allow relative movement between the shelf plate and the body frame, so that vibration isolation for the shelf plate is prevented from being hindered and vibrations are prevented from being transmitted to the shelf plate via the feed tube. Consequently, even when the shelf plate is provided with a purging apparatus, vibrations can be prevented from being transmitted to the container.

In the storage shelf according to one aspect of the present invention, the support may be the body frame. With this configuration, even in the storage shelf having a configuration in which the main tube is fixed to the body frame, vibrations can be prevented from being transmitted to the container.

In the storage shelf according to one aspect of the present invention, the shelf plate may have a rectangular shape in plan view, the feed nozzle may be arranged at one corner portion of the shelf plate, and the other end of the feed tube may be arranged near to another corner portion of the shelf plate that is diagonally opposite to the one corner portion. With this configuration, the positions of the one end and the other end are shifted from each other in both of a first direction parallel to one side of the shelf plate and a second direction parallel to a side orthogonal to the one side, and thus relative movements between the body frame and the shelf plate in the first direction and the second direction can be facilitated.

In the storage shelf according to one aspect of the present invention, an axial direction of the feed tube at the one end and an axial direction thereof at the other end may be orthogonal to each other, and the feed tube may have a curved portion between the one end and the other end. With this configuration, the feed tube can further facilitate both movements in the first direction and the second direction of the shelf plate.

In the storage shelf according to one aspect of the present invention, the feed tube may be arranged along a horizontal direction, and may have the curved portion. With this configuration, even when the space between the body frame and the shelf plate arranged above the body frame with the elastic body interposed therebetween is narrow, the feed tube can be arranged between the body frame and the shelf plate. In other words, an increase in the size of the storage shelf in the vertical direction can be avoided.

The storage shelf according to one aspect of the present invention may further include a filter supported by the body frame and provided between the main tube and the other end of the feed tube. With this configuration, gas can be cleaned at a final end where the gas is fed to the feed tube, and thus higher quality gas can be fed to the container.

### Advantageous Effects of Invention

According to one aspect of the present invention, even when the shelf plate is provided with the purging apparatus, vibrations can be prevented from being transmitted to the container.

### Brief Description of Drawings

[FIG. 1] FIG. 1 is a perspective view illustrating a storage shelf according to one embodiment.
[FIG. 2] FIG. 2 is a perspective view illustrating a shelf plate when viewed from obliquely above.
[FIG. 3] FIG. 3 is a perspective view illustrating the shelf plate when viewed from obliquely below.
[FIG. 4] FIG. 4 is a plan view illustrating the shelf plate when viewed from above.
[FIG. 5] FIG. 5 is a plan view of a shelf plate according to a modification 1 when viewed from above.
[FIG. 6] FIG. 6 is a plan view of a shelf plate according to a modification 2 when viewed from above.

### Description of Embodiments

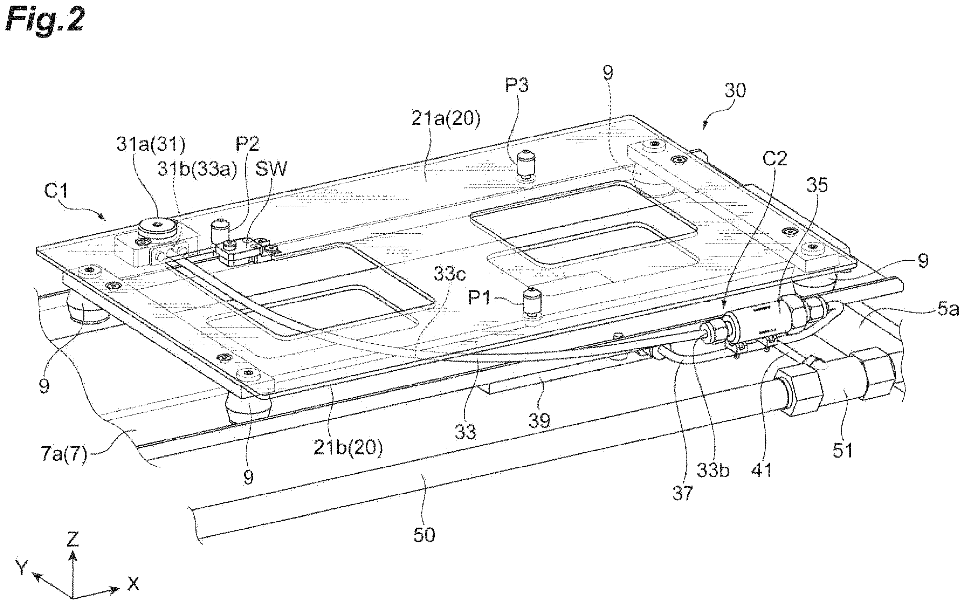

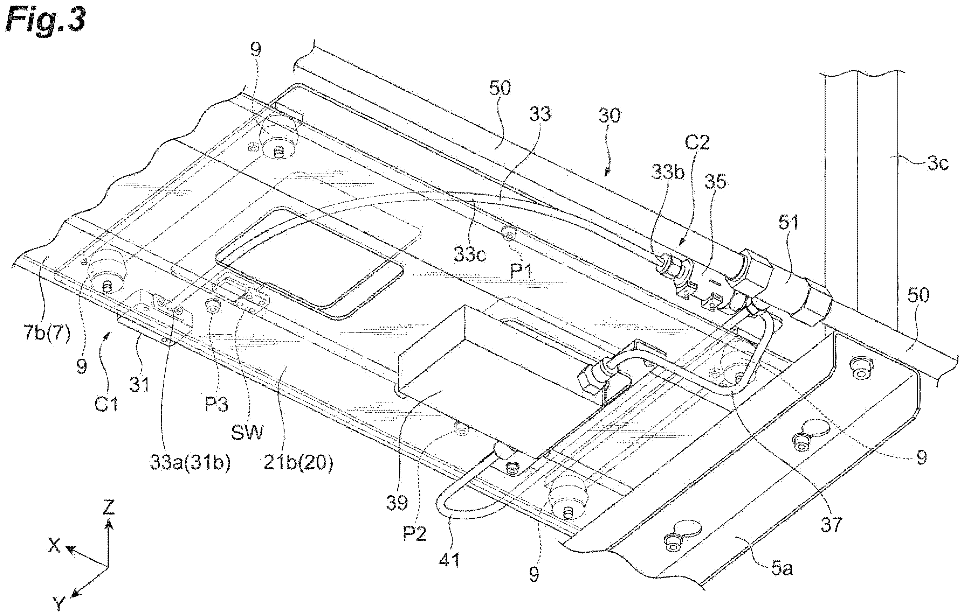

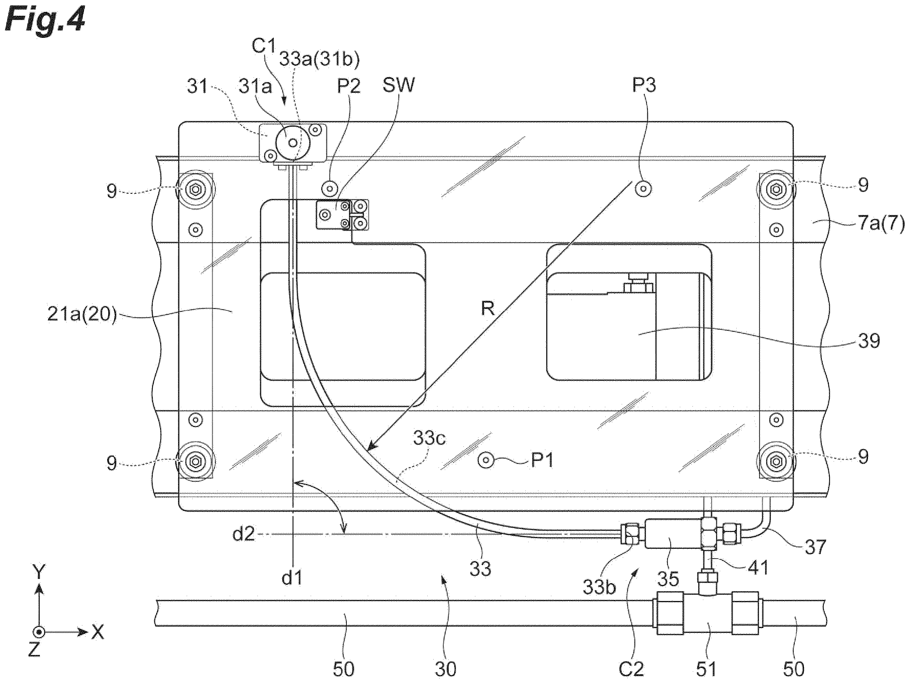

One preferred embodiment of one aspect of the present invention will now be described in detail with reference to the drawings . In the description of the drawings, like elements are designated by like reference signs, and duplicate description is omitted. The terms "X-direction", "Y-direction", and "Z-direction" are based on directions illustrated in the drawings and are given for convenience. In FIG. 2 and FIG. 4, a shelf plate 20 is illustrated in a transparent manner. In FIG. 3, a base member 7 is illustrated in a transparent manner.

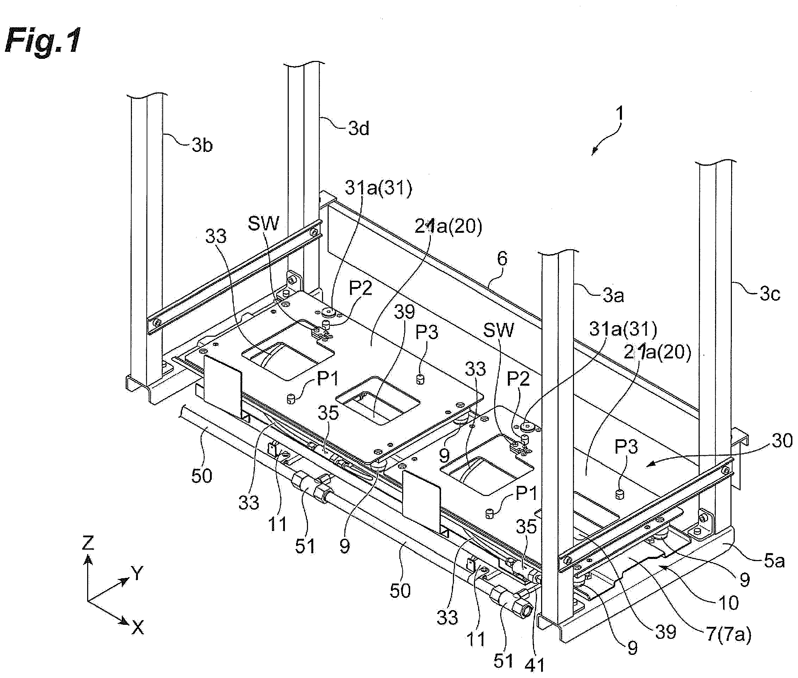

A storage shelf 1 illustrated in FIG. 1 is installed in a semiconductor conveyance system of a semiconductor manufacturing plant, for example. The storage shelf 1 temporarily stores therein a container (containing an object) such as a reticle pod or a FOUP (not illustrated) . The storage shelf 1 includes a body frame 10, shelf plates 20, main tubes 50, and purging apparatuses 30. The body frame 10 supports the shelf plates 20 with elastic bodies 9 interposed therebetween. Examples of the elastic bodies 9 include rubber materials, silicone gel materials, urethan gels, and metal springs. The body frame 10 includes suspending members 3a to 3d, connecting members 5a, 5b, and a base member 7.

The suspending members 3a to 3d are pillar members extending in the vertical direction (Z-direction), provided in plurality (four in the present embodiment). The suspending members 3a to 3d are arranged facing each other spaced at predetermined intervals in the X-direction and the Y-direction. The suspending members 3a to 3d are secured to any one of a rail of an overhead transport vehicle, a supporting member supporting this rail, and a ceiling. On lower-end sides of the suspending members 3a, 3b, a fence member 6 extending in the X-direction is laterally provided. On lower-end sides of the suspending members 3c, 3d, a fence member 6 extending in the X-direction is laterally provided. The fence members 6, 6 prevent a FOUP from falling. In FIG. 1, for convenience in description, illustration of one of the fence members laterally provided on the suspending members 3a, 3b is omitted.

The connecting member 5a is a member extending in the Y-direction, and connects the lower ends of the suspending member 3a and the suspending member 3c. The connecting member 5b is a member extending in the Y-direction, and connects the lower ends of the suspending member 3b and the suspending member 3d. The base member 7 is a plate-like member extending in the X-direction, and is disposed across the connecting members 5a, 5b.

Each shelf plate 20 is a plate-like member having a substantially rectangular shape in plan view when viewed from the Z-direction, and a FOUP is placed thereon. The shelf plates 20 are supported by the elastic bodies 9 arranged on an upper surface 7a of the base member 7. Each shelf plate 20 has a placement surface 21a on which a FOUP is placed and a lower surface 21b that is opposite to the placement surface 21a (see FIG. 2) . The shelf plate 20 is provided with pins P1, P2, P3 and a feed nozzle 31 described later in detail. The pins P1 to P3 protrude upward from the placement surface 21a of the shelf plate 20. The pins P1 to P3 are arranged at positions corresponding to positioning holes (not illustrated) formed in a bottom portion of the FOUP. On the placement surface 21a of the shelf plate 20, a loading sensor SW is provided.

The main tubes 50 are connected to a feed source of gas to be fed to the purging apparatuses 30. Examples of the gas to be fed to the purging apparatuses 30 include nitrogen gas and dry air. Each main tube 50 is a tubular member formed of metal such as stainless steel or resin such as a fluorocarbon polymer. The main tube 50 is supported by a pipe support bracket 11 fixed to the base member 7. The main tube 50 includes a branch portion 51. To the branch portion 51, a second pipe 41 included in the corresponding purging apparatus 30 is connected.

As illustrated in FIG. 2 to FIG. 4, the purging apparatus 30 includes the feed nozzle 31, a feed tube 33, a filter unit 35, a first pipe 37, a mass flow controller (MFC) 39, and the second pipe 41. The feed nozzle 31 is a nozzle configured to feed gas into a FOUP, and has a nozzle portion 31a from which the gas is fed to the FOUP and a connecting portion 31b to which the feed tube 33 is connected. The nozzle portion 31a protrudes upward from the placement surface 21a of the shelf plate 20, and is connected to an introduction hole formed in the bottom surface of the FOUP by placing the FOUP onto the nozzle portion 31a. The connecting portion 31b is provided on the lower surface 21b of the shelf plate 20. The feed nozzle 31 is arranged at one corner portion C1 of the shelf plate 20.

The feed tube 33 has one end 33a communicating with the feed nozzle 31 and the other end 33b communicating with the main tube 50 that is supported by the base member (a support separate from the shelf plate 20) 7 and is connected to the feed source of gas to be fed to a FOUP. In the present embodiment, the other end 33b communicates with the main tube 50 via the filter unit 35, the first pipe 37, the MFC 39, and the second pipe 41. The feed tube 33 is, for example, a tubular member formed of resin such as a fluorocarbon polymer, and has flexibility all along its entire length. The feed tube 33 can keep a state of extending in the horizontal direction between the one end 33a and the other end 33b without being supported by the supporting member.

The axial direction d1 of the feed tube 33 at the one end 33a and the axial direction d2 thereof at the other end 33b are orthogonal to each other, and the feed tube 33 also has a curved portion 33c between the one end 33a and the other end 33b. This curved portion 33c is a flexible part of the feed tube 33. The radius R of the curved portion 33c is 200 millimeters to 250 millimeters, for example. The feed tube 33 having flexibility is bent so that the above-described radius R can be set to a radius of curvature as large as possible in a state in which the one end 33a is connected to the feed nozzle 31 and the other end 33b is connected to the filter unit 35.

The filter unit 35 is a member in which a filter configured to remove foreign matters contained in gas passing through the filter unit 35 is accommodated, and removes foreign matters contained in gas fed from the feed source of the gas via the main tube 50. The other end 33b of the feed tube 33 is connected to the filter unit 35. The filter unit 35 is fixed to the base member 7 by an appropriate member. The filter unit 35 is arranged near to another corner portion C2 of the shelf plate 20 that is diagonally opposite to the one corner portion C1.

The first pipe 37 is a tubular member connecting between the filter unit 35 and the MFC 39. The first pipe 37 is a tubular member formed of metal such as stainless steel. The first pipe 37 is not supported by anything other than connecting portions to the filter unit 35 and the MFC 39.

The MFC 39 is an instrument for measuring the flow rate of gas fed from the main tube 50 and controlling the flow rate. The MFC 39 is controlled by a controller (not illustrated) . The controller controls the MFC 39 such that, if a FOUP has been detected by the loading sensor SW provided on the shelf plate 20, a predetermined flow rate of gas is fed to the FOUP, and controls the MFC 39 such that, if a FOUP has not been detected by the loading sensor SW provided on the shelf plate 20, the gas is not fed to the FOUP. The MFC 39 is fixed to a lower surface 7b of the base member 7 by an appropriate method.

The second pipe 41 is a tubular member connecting between the MFC 39 and the branch portion 51. The second pipe 41 is a tubular member formed of metal such as stainless steel or resin such as a fluorocarbon polymer.

The following describes functional effects of the storage shelf 1 according to the embodiment described above. In the storage shelf 1 according to the embodiment, the feed tube 33 connected to the feed nozzle 31 provided on the shelf plate 20 deforms. Thus, the feed tube 33 can allow relative movement between the shelf plate 20 and the body frame 10 (movements in the X-direction, the Y-direction, and the Z-direction), whereby vibration isolation for the shelf plate 20 is not hindered and vibrations are prevented from being transmitted to the shelf plate 20 via the feed tube 33. Consequently, even when the shelf plate 20 is provided with the purging apparatus 30, vibrations can be prevented from being transmitted to the FOUP.

In the storage shelf 1 according to the embodiment, even in the storage shelf 1 having a configuration in which the main tube 50 is fixed to the body frame 10, vibrations can be prevented from being transmitted to the FOUP.

In the storage shelf 1 according to the embodiment, the positions of the one end 33a and the other end 33b of the feed tube 33 are shifted from each other in both of the X-direction parallel to one side of the shelf plate 20 and the Y-direction parallel to a side orthogonal to the one side. Thus, the feed tube 33 can facilitate relative movements between the base member 7 and the shelf plate 20 in the X-direction and the Y-direction.

In the storage shelf 1 according to the embodiment, the axial direction d1 of the feed tube 33 at the one end 33a and the axial direction d2 thereof at the other end 33b are orthogonal to each other, and the feed tube 33 has the curved portion 33c between the one end 33a and the other end 33b. With this configuration, the feed tube 33 can further facilitate both movements (deformations) in the X-direction and the Y-direction in the shelf plate 20.

In the storage shelf 1 according to the embodiment, the feed tube 33 has the curved portion 33c arranged along the horizontal direction (XY-plane). With this configuration, even when the space between the base member 7 and the shelf plate 20 arranged above the base member 7 with the elastic bodies 9 interposed therebetween is narrow, the feed tube 33 can be arranged between the base member 7 and the shelf plate 20. Consequently, an increase in the size of the storage shelf 1 in the vertical direction can be avoided. Furthermore, the capacity for storing FOUPs per unit area can be increased.

Because the storage shelf 1 according to the embodiment includes the filter unit 35 supported by the base member 7 and provided between the main tube 50 and the other end 33b of the feed tube 33, gas can be cleaned at a final end where the gas is fed to the feed tube 33 (at the other end 33b of the feed tube 33) . Thus, higher quality gas can be fed to the FOUP.

Although one embodiment has been described above, one aspect of the present invention is not limited to the embodiment, and various modifications may be made within the scope not departing from the gist of the invention.

### <Modification 1>

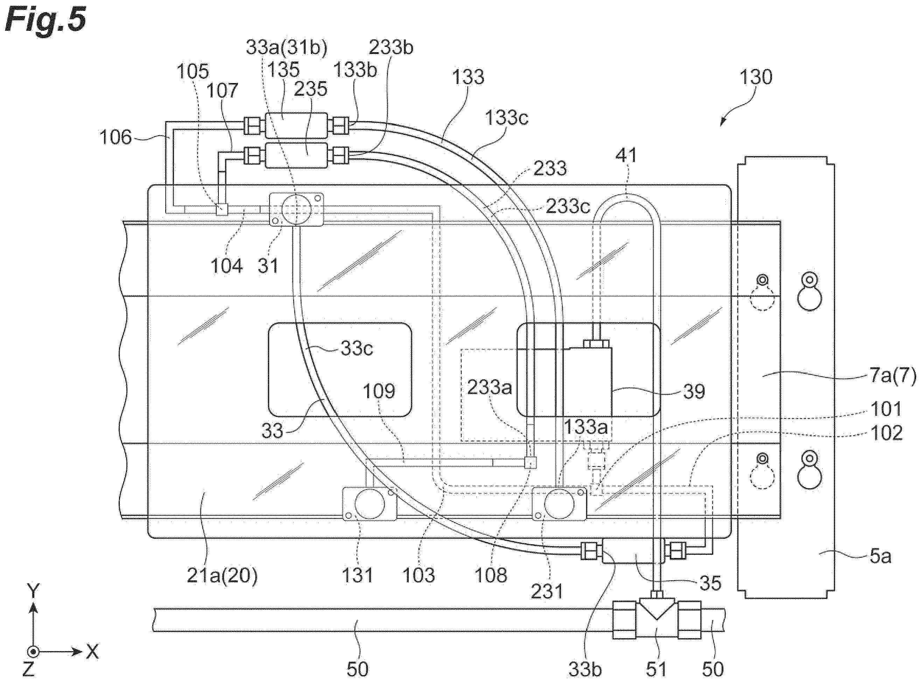

In the embodiment, an example has been described in which the storage shelf 1 is configured such that each shelf plate 20 is provided with one feed nozzle 31. However, the storage shelf 1 may be configured such that each shelf plate 20 is provided with a plurality of feed nozzles and a plurality of feed tubes. For example, as illustrated in FIG. 5, each shelf plate 20 of a storage shelf 1 according to a modification 1 may be provided with three feed nozzles 31, 131, 231 and three feed tubes 33, 133, 233 configured to feed gas to the three feed nozzles 31, 131, 231, respectively. In plan view when viewed from the Z-direction, the three feed tubes 33, 133, 233 are arranged so as not to overlap each other in a planar manner.

In a purging apparatus 130 of the storage shelf 1 according to the modification 1, a branch portion 101 is provided downstream of the MFC 39, the filter unit 35 is connected to one end of the branch portion 101 with a metal tube 102 interposed therebetween, and a filter unit 135 and a filter unit 235 are each connected to the other end of the branch portion 101 with a metal tube 103, a branch portion 105, a metal tube 106, and a metal tube 107 interposed therebetween. The filter units 35, 135, 235 are fixed to the base member 7 by an appropriate method.

The one end 33a of the feed tube 33 is connected to the feed nozzle 31, and the other end 33b thereof is connected to the filter unit 35. One end 133a of the feed tube 133 is connected to the feed nozzle 131, and the other end 133b thereof is connected to the filter unit 135. One end 233a of the feed tube 233 communicates with the feed nozzle 231, and the other end 233b thereof is connected to the filter unit 235. The one end 233a of the feed tube 233 is connected to the feed nozzle 31 with an elbow joint 108 and a metal tube 109 interposed therebetween. The elbow joint 108 is fixed to the shelf plate 20. The feed tubes 33, 133, 233 are formed of flexible tubes made of resin.

In the storage shelf 1 according to the modification 1, the feed tubes 33, 233 that are respectively connected to the feed nozzles 31, 231 provided on the shelf plate 20 deform. The feed tubes 33, 233 also have curved portions 33c, 233c, respectively. Thus, the feed tubes 33, 233 allow relative movement between the shelf plate 20 and the body frame 10. The metal tube 109 connected to the feed nozzle 231 provided on the shelf plate 20 is connected to the elbow joint 108. The feed tube 233 connected to the elbow joint 108 deforms. The feed tube 233 has the curved portion 233c. With the configuration of the feed tubes 33, 133, 233 thus connected, vibration isolation for the shelf plate 20 is not hindered and vibrations are prevented from being transmitted to the shelf plate 20 via the feed tubes 33, 133, 233. Consequently, even when the shelf plate 20 is provided with the purging apparatus, vibrations can be prevented from being transmitted to the FOUP.

In the storage shelf 1 according to the modification 1, in plan view when viewed from the Z-direction, the three feed tubes 33, 133, 233 are arranged so as not to overlap each other in a planner manner, and thus an increase in the size of the storage shelf 1 in the Z-direction (vertical direction) can be avoided. In the storage shelf 1 according to the modification 1, the feed tube 33 having the curved portion 33c and the feed tubes 133, 233 having the curved portion 133c, 233c are arranged so as to be opposed to each other in a concavely bent manner. Thus, within a limited space in plan view, the feed tubes 33, 133, 233 can be arranged in a flexible manner.

### <Modification 2>

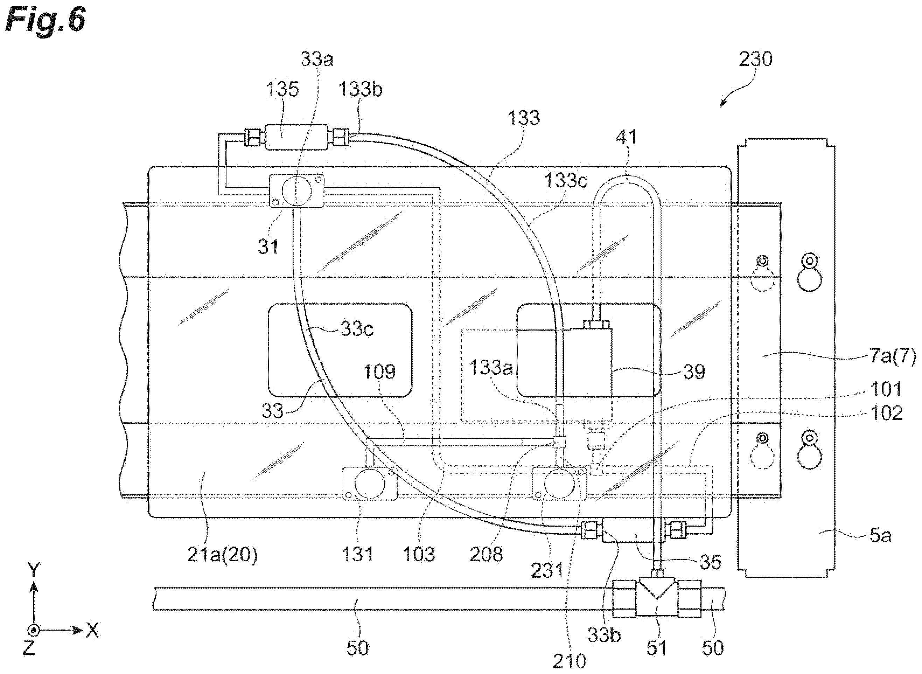

In the modification 1, an example has been described in which, when the three feed nozzles 31, 131, 231 are arranged, the feed tubes 33, 133, 233 having flexibility and respectively connected to the three feed nozzles 31, 131, 231 are provided. However, the present invention is not limited to this. For example, as illustrated in FIG. 6, each shelf plate 20 of a storage shelf 1 according to a modification 2 may be provided with the three feed nozzles 31, 131, 231, the feed tube 33 configured to feed gas to the feed nozzle 31, and the feed tube 133 configured to feed gas to the two feed nozzles 131, 231. In plan view when viewed from the Z-direction, the two feed tubes 33, 133 are arranged so as not to overlap each other in a planner manner.

In a purging apparatus 230 according to the modification 2, the branch portion 101 is provided downward of the MFC 39, the filter unit 35 is connected to one end of the branch portion 101 with the metal tube 102 interposed therebetween, and the filter unit 135 is connected to the other end of the branch portion 101 with the metal tube 103 interposed therebetween. The filter units 35, 135 are fixed to the base member 7 by an appropriate method.

The one end 33a of the feed tube 33 is connected to the feed nozzle 31, and the other end 33b thereof is connected to the filter unit 35. The one end 133a of the feed tube 133 communicates with each of the feed nozzles 131, 231, and the other end 133b thereof is connected to the filter unit 135. The one end 133a of the feed tube 133 is connected to a branch portion 208 fixed to the shelf plate 20. One end of the branch portion 208 is connected to the feed nozzle 131 with a metal tube 210 interposed therebetween, and the other end of the branch portion 208 is connected to the feed nozzle 231 with a metal tube 209 interposed therebetween. The feed tubes 33, 133 are formed of flexible tubes made of resin.

In the storage shelf 1 according to the modification 2, the feed tube 33 connected to the feed nozzle 31 provided on the shelf plate 20 deforms. The feed tube 33 has the curved portion 33c. Thus, the feed tube 33 allows relative movement between the shelf plate 20 and the body frame 10. The metal tubes 209, 210 that are respectively connected to the feed nozzles 131, 231 provided on the shelf plate 20 are connected to the branch portion 208. The feed tube 133 connected to the branch portion 208 can deform. The feed tube 133 has the curved portion 133c. With the configuration of the feed tubes 33, 133 thus connected, vibration isolation for the shelf plate 20 is not hindered and vibrations are prevented from being transmitted to the shelf plate 20 via the feed tubes 33, 133. Consequently, even when the shelf plate 20 is provided with the purging apparatus, vibrations can be prevented from being transmitted to the FOUP.

In the storage shelf 1 according to the modification 2, in plan view when viewed from the Z-direction, the two feed tubes 33, 133 are arranged so as not to overlap each other in a planner manner, and thus increase in size of the storage shelf 1 in the Z-direction (vertical direction) can be suppressed. In the storage shelf 1 according to the modification 2, the feed tube 33 having the curved portion 33c and the feed tube 133 having the curved portion 133c are arranged so as to be opposed to each other in a concavely bent manner. Thus, within a limited space in plan view, the feed tubes 33, 133 can be arranged in a curved manner.

### <Other Modifications>

In the embodiment, an example has been described in which the one end 33a of the feed tube 33 is directly connected to the connecting portion 31b of the feed nozzle 31. However, the one end 33a may be connected to the connecting portion 31b with an elbow joint bendable at any angle (e.g., 90 degrees) interposed therebetween. This configuration can be applied even to arrangement in which the feed tube 33 having flexibility cannot fit.

In the embodiment and the modifications, examples have been described in which the filter unit 35 is arranged at the other end 33b of the feed tube 33, that is, the feed tube 33 is interposed between the filter unit 35 and the feed nozzle 31. However, the present invention is not limited to this. For example, the filter unit 35 may be arranged at the one end 33a of the feed tube 33, that is, the filter unit 35 may be interposed between the feed tube 33 and the feed nozzle 31.

In the embodiment and the modifications, examples have been described in which the feed tubes 33, 133, 233 are arranged in a manner bent in a horizontal plane. However, for example, the feed tubes 33, 133, 233 may be arranged in a manner bent in a vertical plane. In other words, the feed tubes 33, 133, 233 may be arranged in a manner hanging downward.

In the embodiment and the modifications, examples have been described in which the main tube 50 is supported by the pipe support bracket 11 fixed to the base member 7. However, for example, the main tube 50 may be supported by a traveling rail along which overhead transport vehicles travel, may be supported by a supporting member installed to a ceiling or the like of a clean room, for example, or may be supported directly by the ceiling.

In the embodiment and the modifications, examples have been described in which the storage shelf 1 is suspended from the ceiling. However, the storage shelf 1 may be installed on a floor. Specifically, the body frame 10 may be installed in a manner standing on the floor.

In the embodiment and the modifications, examples have been described in which the feed tubes 33, 133, 233 have flexibility all along their entire lengths. However, the feed tubes 33, 133, 233 may have flexibility only partially along the entire lengths. Instead of the feed tubes 33, 133, 233 made of resin, for example, accordion tubes made of resin or metal may be used.

### Reference Signs List

1 ... storage shelf, 3a, 3b, 3c, 3d ... suspending member, 5a, 5b ... connecting member, 6 ... fence member, 7 ... base member, 10 ... body frame, 20 ... shelf plate, 21a ... placement surface, 30, 130, 230 ... purging apparatus, 31, 131, 231 ... feed nozzle, 31a ... nozzle portion, 31b ... connecting portion, 33, 133, 233 ... feed tube, 33a, 133a, 233a ... one end, 33b, 133b, 233b ... the other end, 33c, 133c, 233c ... curved portion, 35, 135, 235 ... filter unit, 50 ... main tube, 51 ... branch portion, C1, C2 ... corner portion, d1 ... axial direction, d2 ... axial direction, P1, P2, P3 ... pin

## Claims

1. A storage shelf (1) including a body frame (10) and a plate-like shelf plate (20), the body frame (10) including a plate-like base member (7), the shelf plate (20) being attached to the base member (7) with an elastic body (9) interposed therebetween, the storage shelf (1) configured to store therein a container containing a contained object, the storage shelf (1) being **characterized by** afeednozzle (31) provided on the shelf plate (20) and configured to feed gas to the container; and
a feed tube (33) having one end (33a) communicating with the feed nozzle (31) and the other end (33b) communicating with a main tube (50) connected to a feed source of the gas to be fed to the container, the main tube (50) being supported by a support (11) separate from the shelf plate (20), wherein
the feed tube (33) has a flexible part (33c) having flexibility at least partially between the one end (33a) and the other end (33b), and is arranged in a space formed between the plate-like base member (7) and the plate-like shelf plate (20).

2. The storage shelf (1) according to claim 1, wherein the support (11) is the body frame (10).

3. The storage shelf (1) according to claim 1 or 2, wherein
the shelf plate (20) has a rectangular shape in plan view,
the feed nozzle (31) is arranged at one corner portion (C1) of the shelf plate (20), and
the other end (33b) of the feed tube (33) is arranged near to another corner portion (C2) of the shelf plate (20) that is diagonally opposed to the one corner portion (C1).

4. The storage shelf (1) according to any one of claims 1 to 3, wherein an axial direction of the feed tube (33) at the one end (33a) and an axial direction thereof at the other end (33b) are orthogonal to each other, and the feed tube (33) has a curved portion between the one end (33a) and the other end (33b).

5. The storage shelf (1) according to any one of claims 1 to 4, wherein the feed tube (33) is arranged along a horizontal direction.

6. The storage shelf (1) according to claim 1 or 2, further comprising a filter (35) supported by the body frame (10) and provided between the main tube (50) and the other end (33b) of the feed tube (33).

7. The storage shelf (1) according to any one of claims 1 to 6, wherein
the body frame (10) further includes
suspending members (3a, 3b, 3c, 3d) extending downward and secured to any one of a rail of an overhead transport vehicle, a supporting member supporting the rail, and a ceiling, and
connecting members (5a, 5b) connecting between lower ends of the suspending members (3a, 3b, 3c, 3d),
the base member (7) is disposed across the connecting members (5a, 5b),
the shelf plate (20) includes
the feed nozzle (31), and
a pin (P1, P2, P3) for positioning the container, and the main tube (50) is supported by the base member (7).

## Patentansprüche

1. Lagerfach (1), das einen Rumpfrahmen (10) und eine plattenartige Fachplatte (20) enthält, wobei der Rumpfrahmen (10) ein plattenartiges Basiselement (7) enthält, wobei die Fachplatte (20) an dem Basiselement (7) mit einem dazwischen eingefügten elastischen Körper (9) angebracht ist, wobei das Lagerfach (1) konfiguriert ist, um darin einen Behälter aufzubewahren, der ein aufgenommenes Objekt enthält, wobei das Lagerfach (1) durch eine Zuführdüse (31) gekennzeichnet ist, die an der Fachplatte (20) vorgesehen und konfiguriert ist, um dem Behälter Gas zuzuführen; und
ein Zuführrohr (33), dessen eines Ende (33a) mit der Zuführdüse (31) in Verbindung steht und dessen anderes Ende (33b) mit einem Hauptrohr (50) in Verbindung steht, das mit einer Zuführquelle des dem Behälter zuzuführenden Gases verbunden ist, wobei das Hauptrohr (50) an einem von der Fachplatte (20) getrennten Träger (11) getragen wird, wobei
das Zuführrohr (33) ein flexibles Teil (33c) hat, das zumindest teilweise zwischen dem einen Ende (33a) und dem anderen Ende (33b) Flexibilität hat und in einem Raum angeordnet ist, der zwischen dem plattenartigen Basiselement (7) und der plattenartigen Fachplatte (20) ausgebildet ist.

2. Das Lagerfach (1) nach Anspruch 1, wobei der Träger (11) der Rumpfrahmen (10) ist.

3. Das Lagerfach (1) nach Anspruch 1 oder 2, wobei
die Fachplatte (20) in Draufsicht eine rechteckige Form hat,
die Zuführdüse (31) an einem Eckabschnitt (C1) der Fachplatte (20) angeordnet ist, und
das andere Ende (33b) des Zuführrohrs (33) nahe einem anderen Eckabschnitt (C2) der Fachplatte (20) angeordnet ist, der dem einen Eckabschnitt (C1) diagonal gegenüberliegt.

4. Das Lagerfach (1) nach einem der Ansprüche 1 bis 3, wobei eine axiale Richtung des Zuführrohrs (33) an dem einen Ende (33a) und dessen axiale Richtung an dem anderen Ende (33b) zueinander orthogonal sind, und das Zuführrohr (33) zwischen dem einen Ende (33a) und dem anderen Ende (33b) einen gekrümmten Abschnitt hat.

5. Das Lagerfach (1) nach einem der Ansprüche 1 bis 4, wobei das Zuführrohr (33) entlang einer horizontalen Richtung angeordnet ist.

6. Das Lagerfach (1) nach Anspruch 1 oder 2, das ferner einen Filter (35) aufweist, der an dem Rumpfrahmen (10) getragen und zwischen dem Hauptrohr (50) und dem anderen Ende (33b) des Zuführrohrs (33) vorgesehen ist.

7. Das Lagerfach (1) nach einem der Ansprüche 1 bis 6, wobei der Rumpfrahmen (10) ferner enthält:
Aufhängungselemente (3a, 3b, 3c, 3d), die sich nach unten erstrecken und an einer Schiene eines Überkopftransportfahrzeugs oder einem die Schiene tragenden Trägerelement oder einer Decke gesichert ist, und
Verbindungselemente (5a, 5b), die untere Enden der Aufhängungselemente (3a, 3b, 3c, 3d) dazwischen verbinden,
das Basiselement (7) quer zu den Verbindungselementen (5a, 5b) angeordnet ist,
die Fachplatte (20) enthält:
die Zuführdüse (31), und
einen Stift (P1, P2, P3) zum Positionieren des Behälters, und
das Hauptrohr (50) an dem Basiselement (7) getragen ist.

## Revendications

1. Compartiment de stockage (1) comprenant un cadre de corps (10) et une plaque de compartiment en forme de plaque (20), le cadre de corps (10) comprenant un élément de base en forme de plaque (7), la plaque de compartiment (20) étant fixée à l'élément de base (7) avec un corps élastique (9) interposé entre ceux-ci, le compartiment de stockage (1) configuré pour stocker en son sein un conteneur contenant un objet contenu, le compartiment de stockage (1) étant **caractérisé par** une buse d'alimentation (31) prévue sur la plaque de compartiment (20) et configurée pour alimenter en gaz le conteneur ; et
un tube d'alimentation (33) ayant une extrémité (33a) communiquant avec la buse d'alimentation (31) et l'autre extrémité (33b) communiquant avec un tube principal (50) connecté à une source d'alimentation du gaz destiné à l'alimentation du conteneur, le tube principal (50) étant supporté par un support (11) séparé de la plaque de compartiment (20), dans lequel
le tube d'alimentation (33) a une partie flexible (33c) ayant une flexibilité au moins partiellement entre l'extrémité (33a) et l'autre extrémité (33b), et est agencé dans un espace formé entre l'élément de base en forme de plaque (7) et la plaque de compartiment en forme de plaque (20).

2. Compartiment de stockage (1) selon la revendication 1, dans lequel le support (11) est le cadre de corps (10).

3. Compartiment de stockage (1) selon la revendication 1 ou 2, dans lequel la plaque de compartiment (20) a une forme rectangulaire dans une vue en plan,
la buse d'alimentation (31) est agencée au niveau d'une portion de coin (C1) de la plaque de compartiment (20), et
l'autre extrémité (33b) du tube d'alimentation (33) est agencée près d'une autre portion de coin (C2) de la plaque de compartiment (20) qui est diagonalement opposée à la partie de coin (C1).

4. Compartiment de stockage (1) selon l'une quelconque des revendications 1 à 3, dans lequel une direction axiale du tube d'alimentation (33) au niveau de l'extrémité (33a) et une direction axiale de celui-ci au niveau de l'autre extrémité (33b) sont orthogonales l'une à l'autre, et le tube d'alimentation (33) a une portion incurvée entre l'extrémité (33a) et l'autre extrémité (33b).

5. Compartiment de stockage (1) selon l'une quelconque des revendications 1 à 4, dans lequel le tube d'alimentation (33) est agencé le long d'une direction horizontale.

6. Compartiment de stockage (1) selon la revendication 1 ou 2, comprenant en outre un filtre (35) supporté par le cadre de corps (10) et prévu entre le tube principal (50) et l'autre extrémité (33b) du tube d'alimentation (33).

7. Compartiment de stockage (1) selon l'une quelconque des revendications 1 à 6, dans lequel
le cadre de corps (10) comprend en outre
des éléments de suspension (3a, 3b, 3c, 3d) s'étendant vers le bas et fixés à l'un quelconque parmi un rail d'un véhicule de transport aérien, un élément de support supportant le rail, et un plafond, et
des éléments de connexion (5a, 5b) se connectant entre des extrémités inférieures des éléments de suspension (3a, 3b, 3c, 3d),
l'élément de base (7) est disposé à travers les éléments de connexion (5a, 5b),
la plaque de compartiment (20) comprend
la buse d'alimentation (31), et
une broche (P1, P2, P3) pour positionner le conteneur, et le tube principal (50) est supporté par l'élément de base (7).
